# EUROPEAN PATENT APPLICATION

(11) **EP 3 321 391 A1**
(43) Date of publication of application: **16.05.2018**
(21) Application number: 16824406.9
(22) Date of filing: 08.07.2016
(51) Int. Cl.: C23C 16/455, B23B 27/14

(54) **CHEMICAL VAPOR DEPOSITION DEVICE AND CHEMICAL VAPOR DEPOSITION METHOD**

(30) Priority: 10.07.2015 JP 2015138721; 07.07.2016 JP 2016135275
(71) Applicant: Mitsubishi Materials Corporation, Chiyoda-ku Tokyo 100-8117 (JP)
(72) Inventor: TATSUOKA Sho, Naka-shi Ibaraki 311-0102 (JP); YAMAGUCHI Kenji, Naka-shi Ibaraki 311-0102 (JP)
(74) Representative: Gille Hrabal
(86) International application number: PCT/JP2016/070292
(87) International publication number: WO 2017/010426

(57) **Abstract**

A chemical vapor deposition apparatus includes a reaction chamber in which a deposition material is accommodated, a gas supply tube provided in the reaction chamber, and a rotary drive device that rotates the gas supply tube around a rotation axis in the reaction chamber, in which an inside of the gas supply tube is partitioned into the first and second gas flowing sections extending along the rotation axis, a set of gas ejection ports including at least three or more the gas ejection ports disposed, lying next to each other in the circumferential direction is installed on the tube wall, and the set of gas ejection ports includes at least one of a first gas ejection port ejecting the first gas flowing through the first gas flowing section, and at least one of the second gas ejection port ejecting a second gas flowing through the second gas flowing section.

## Description

### Technical Field

The present invention relates to a chemical vapor deposition apparatus and a chemical vapor deposition method.

Priority is claimed on Japanese Patent Application No. 2015-138721, filed on July 10, 2015, and Japanese Patent Application No. 2016-135275 filed on July 7, 2016, the content of which are incorporated herein by reference.

### Background Art

A cutting tool having a hard layer coated on a surface has been used in the related art. For example, there is known a surface coated cutting tool in which WC-based cemented carbide or the like is used as a body and a hard layer such as TiC, TiN or the like is coated on the surface of the cutting tool by a chemical vapor deposition method. As an apparatus for coating a hard layer on a surface of a cutting tool body, for example, chemical vapor deposition apparatuses described in PTLS 1 to 3 are known.

### Citation List

### Patent Literature

[PTL 1] Japanese Unexamined Patent Application, First Publication No. H05-295548
[PTL 2] Published Japanese Translation No. 2011-528753 of the PCT International Publication
[PTL 3] Japanese Unexamined Patent Application, First Publication No. H 09-310179

### Summary of Invention

### Technical Problem

In chemical vapor deposition apparatuses described in PTLS 1 and 2, a tray on which a cutting tool body is mounted in a reaction chamber is stacked in the vertical direction, and the raw material gas is dispersed by rotating a gas supply tube extending in the vertical direction in the vicinity of the tray. In addition, in a chemical vapor deposition apparatus described in PTL 3, for the purpose of avoiding an operational trouble due to occlusion of a gas inlet and performing stable chemical vapor deposition, a decompression type vertical chemical vapor deposition apparatus in which two gas inlets (or two or more) are provided in a baseplate has been proposed.

However, in a case where gases having high reaction activity with each other are used as raw material gases, the raw material gases are likely to react in a supply path. Therefore, a reaction product generated by the reaction of the raw material gas is deposited in the gas supply tube or a gas ejection port, which may cause a problem in gas supply. As a result, a reaction state of the gas varies, and the uniformity of the film quality of each cutting tool in the reaction chamber decreases in some cases.

It is an object of the present invention to provide a chemical vapor deposition apparatus and a chemical vapor deposition method capable of forming a uniform film on a plurality of deposition materials.

### Solution to Problem

According to an aspect of the present invention, there is provided a chemical vapor deposition apparatus that includes a reaction chamber in which a deposition material is accommodated, a gas supply tube provided in the reaction chamber, and a rotary drive device configured to rotate the gas supply tube around a rotation axis in the reaction chamber, in which an inside of the gas supply tube is partitioned into a first gas flowing section and a second gas flowing section which extend along the rotation axis, a set of gas ejection ports including at least three or more the gas ejection ports disposed, lying next to each other in the circumferential direction is installed on a tube wall of the gas supply tube, and the set of gas ejection ports includes at least one of a first gas ejection port that ejects a first gas flowing through the first gas flowing section into the reaction chamber, and at least one of a second gas ejection port that ejects a second gas flowing through the second gas flowing section into the reaction chamber.

In the set of the gas ejection ports, a relative angle of the two gas ejection ports disposed in the same gas flowing section around the rotation axis may be configured to be 60° or more.

A plurality of sets of the gas ejection ports may be configured to be provided in the axial direction of the gas supply tube.

A tray having a mounting surface on which the deposition material is mounted is further included, in which the mounting surface of the tray may be configured to be disposed towards an axial direction of the gas supply tube.

A plurality of the trays may be configured to be stacked and disposed along the axial direction of the gas supply tube.

The tray may have a through-hole, and the gas supply tube ports may be configured to be inserted into the through-hole.

According to another aspect of the present invention, there is provided a chemical vapor deposition method that includes forming a film on a surface of a deposition material by using the chemical vapor deposition apparatus.

In the chemical vapor deposition method, the gas supply tube may be rotated at a rotation speed of 10 rotations or more per minute and 60 rotations or less per minute.

In the chemical vapor deposition method, a raw material gas free of a metal element may be used as the first gas, and a raw material gas containing the metal element may be used as the second gas.

In the chemical vapor deposition method, a raw material gas free of a metal element may be used as the second gas, and a raw material gas containing the metal element may be used as the first gas.

In the chemical vapor deposition method, an ammonia-containing gas may be used as the above-described first or second gas free of the metal element.

### Advantageous Effects of Invention

According to the aspect of the present invention, there is provided the chemical vapor deposition apparatus and the chemical vapor deposition method capable of forming a uniform film on a plurality of deposition materials.

### Brief Description of Drawings

FIG. 1 is a sectional view of a chemical vapor deposition apparatus according to an embodiment.
FIG. 2 is a sectional view illustrating a gas supply tube and a rotary drive device.
FIG. 3 is a cross-sectional view of the gas supply tube.
FIG. 4 is a partial perspective view of the gas supply tube.
FIG. 5A is an explanatory diagram relating to disposition of a gas ejection port.
FIG. 5B is an explanatory diagram relating to disposition of the gas ejection port.
FIG. 5C is an explanatory diagram relating to disposition of the gas ejection port.
FIG. 6 is a sectional view illustrating another example of the gas supply tube.
FIG. 7 is a sectional view illustrating another example of the gas supply tube.

### Description of Embodiments

Hereinafter, embodiments of the present invention will be described with reference to the drawings.

### (Chemical Vapor Deposition Apparatus)

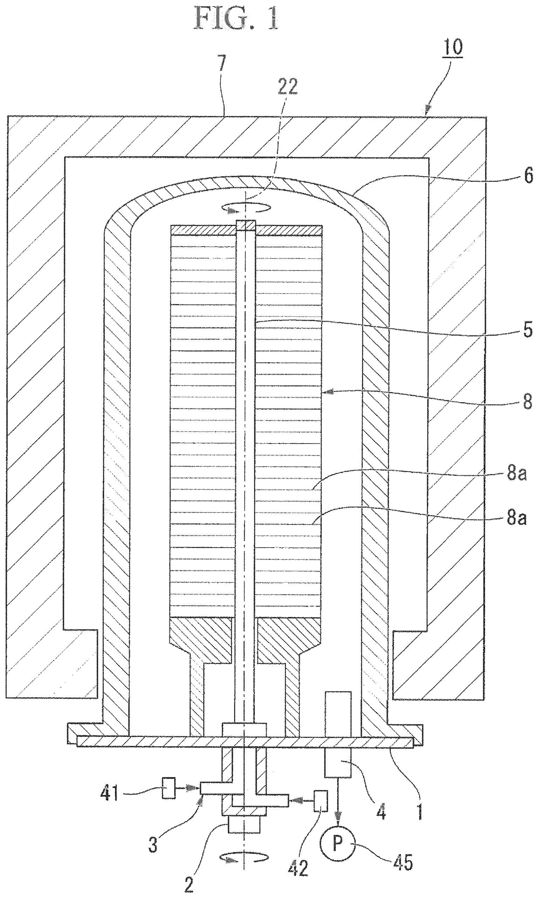

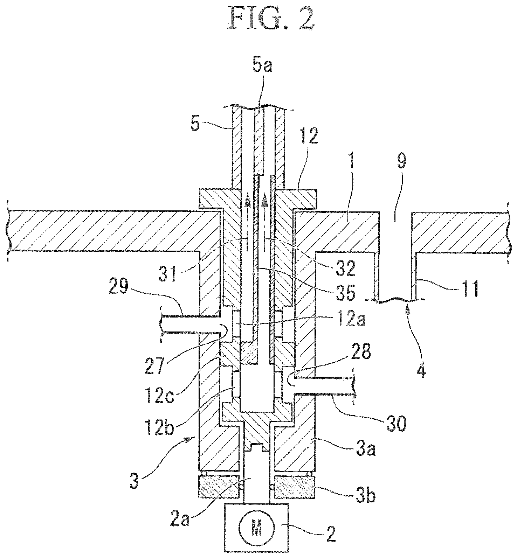

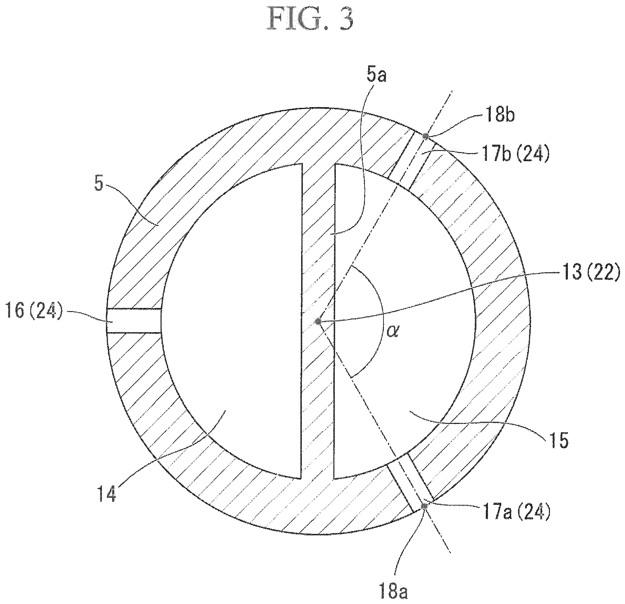

FIG. 1 is a sectional view of a chemical vapor deposition apparatus according to an embodiment. FIG. 2 is a sectional view illustrating a gas supply tube and a rotary drive device. FIG. 3 is a cross-sectional view of the gas supply tube.

A chemical vapor deposition apparatus 10 of the embodiment is a chemical vapor deposition (CVD) apparatus which forms a film on a surface of a deposition material by reacting a plurality of raw material gases in a heated atmosphere. The chemical vapor deposition apparatus 10 of the embodiment can be suitably used for manufacturing a surface coated cutting tool coating a hard layer on the surface of a cutting tool body including cemented carbide or the like.

Examples of the cutting tool body include WC-based cemented carbide, a TiCN-based cermet, a Si₃N₄-based ceramic, an Al₂O₃₋based ceramic, a cBN-based ultra high pressure sintered material, and the like. Examples of the hard layer include an AlTiN layer, a TiSiN layer, and the like.

As illustrated in FIG. 1, the chemical vapor deposition apparatus 10 of the embodiment is provided with a baseplate 1, a work accommodation portion 8 installed on the baseplate 1, a bell-shaped reaction chamber 6 covered on the baseplate 1 and covering the work accommodation portion 8, and a box-shaped outside thermal heater 7 covering a side surface and upper surface of the reaction chamber 6. In the chemical vapor deposition apparatus 10 of the embodiment, a connection part between the baseplate 1 and the reaction chamber 6 is sealed, and an internal space of the reaction chamber 6 can be kept in a depressed pressure atmosphere.

The outside thermal heater 7 heats and holds the inside of the reaction chamber 6 to a predetermined Deposition temperature (for example, 700°C to 1,050°C).

The work accommodation portion 8 is formed by stacking a plurality of trays 8a on which the cutting tool body serving as the deposition material is mounted in the vertical direction. The neighboring trays 8a are disposed with a gap sufficient for flow of the raw material gas. All trays 8a of the work accommodation portion 8 have a through-hole through which the gas supply tube 5 is inserted in the center. In this embodiment, the upper surface of the tray 8a is a mounting surface on which the cutting tool body is mounted. Since each tray 8a is horizontally disposed and the gas supply tube 5 extends in the vertical direction, the mounting surface (upper surface) of the tray 8a is disposed facing the axial direction of the gas supply tube 5.

In the baseplate 1, a gas feeding part 3, a gas exhaust part 4, and a gas supply tube 5 are provided.

The gas feeding part 3 is provided penetrating the baseplate 1 and supplies two types of the raw material gas group A (first gas) and the raw material gas group B (second gas) to the internal space of the reaction chamber 6. The gas feeding part 3 is connected to the gas supply tube 5 inside the baseplate 1 (reaction chamber 6 side). The gas feeding part 3 has a raw material gas group A introduction pipe 29 connected to a raw material gas group A source 41 and a raw material gas group B introduction pipe 30 connected to a raw material gas group B source 42. The raw material gas group A introduction pipe 29 and the raw material gas group B introduction pipe 30 are connected to the gas supply tube 5. The gas feeding part 3 is provided with a motor (rotary drive device) 2 for rotating the gas supply tube 5.

The gas exhaust part 4 is provided through the baseplate 1 and connects a vacuum pump 45 and the internal space of the reaction chamber 6. The vacuum pump 45 evacuates the reaction chamber 6 through the gas exhaust part 4.

The gas supply tube 5 is a tubular member extending vertically upward from the baseplate 1. The gas supply tube 5 is disposed through a central portion of the work accommodation portion 8 in the vertical direction. In the case of the embodiment, an upper end of the gas supply tube 5 is sealed, and the raw material gas group is injected to the outside from the side surface of the gas supply tube 5.

FIG. 2 is a sectional view illustrating the baseplate 1, the gas feeding part 3, and the gas exhaust part 4.

The gas exhaust part 4 has a gas exhaust pipe 11 connected to a gas outlet 9 penetrating the baseplate 1. The gas exhaust pipe 11 is connected to the vacuum pump 45 illustrated in FIG. 1.

The gas feeding part 3 has a tubular support part 3a extending outward from the lower surface of the baseplate 1, a rotary gas introduction part 12 accommodated in the support part 3a, a motor 2 connected to the rotary gas introduction part 12 through a coupling 2a, and a sliding part 3b that seals while sliding the coupling 2a.

The inside of the support part 3a communicates with the inside of the reaction chamber 6. The support part 3a is provided with a raw material gas group A introduction pipe 29 and a raw material gas group B introduction pipe 30 penetrating the side wall of the support part 3a. The raw material gas group A introduction pipe 29 is provided closer to the reaction chamber 6 than the raw material gas group B introduction pipe 30 in the vertical direction. The raw material gas group A introduction pipe 29 has a raw material gas group A inlet 27 that opens on an inner peripheral surface of the support part 3a. The raw material gas group B introduction pipe 30 has a raw material gas group B inlet 28 that opens on an inner peripheral surface of the support part 3a.

The rotary gas introduction part 12 is cylindrical in shape, coaxial with the support part 3a. The rotary gas introduction part 12 is inserted into the support part 3a and driven to rotate around the axis of a rotation axis 22 by the motor 2 connected to the end part (lower end part) opposite to the reaction chamber 6.

The rotary gas introduction part 12 is provided with a through-hole 12a and a through-hole 12b penetrating the side wall of the rotary gas introduction part 12. The through-hole 12a is provided at the same height position as the raw material gas group A inlet 27 of the support part 3a. The through-hole 12b is provided at the same height position as the raw material gas group B inlet 28. A sealing part 12c formed to have a diameter larger than the other parts is provided between the through-hole 12a and the through-hole 12b among an outer peripheral surface of the rotary gas introduction part 12. The sealing part 12c abuts on the inner peripheral surface of the support part 3a and segregates the raw material gas group A that flows in from the raw material gas group A inlet 27 and the raw material gas group B that flows in from the raw material gas group B inlet 28 from each other.

A partition member 35 is provided inside the rotary gas introduction part 12. The partition member 35 partitions into a raw material gas group A introduction path 31 and a raw material gas group B introduction path 32 extending along the height direction (axial direction) inside the rotary gas introduction part 12. The raw material gas group A introduction path 31 is connected to the raw material gas group A inlet 27 through the through-hole 12a. The raw material gas group B introduction path 32 is connected to the raw material gas group B inlet 28 through the through-hole 12b. The gas supply tube 5 is connected to the upper end of the rotary gas introduction part 12.

Hereinafter, the structure of the gas supply tube 5 will be described in detail.

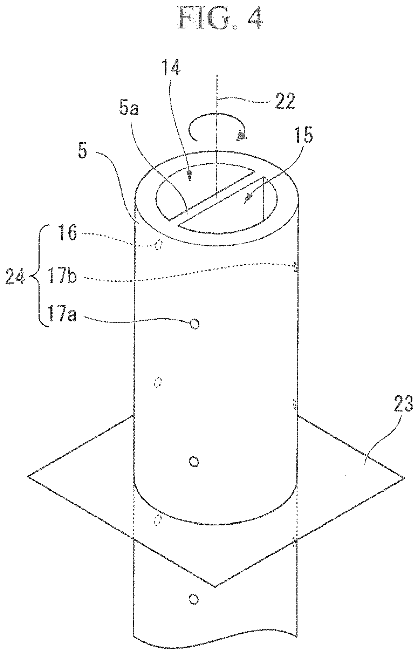

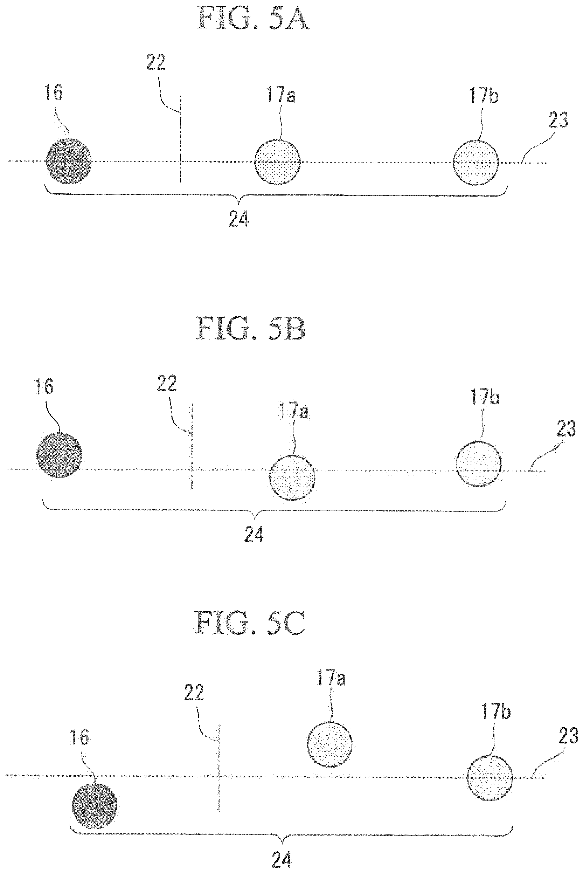

FIG. 3 is a cross-sectional view of the gas supply tube 5. FIG. 4 is a partial perspective view of the gas supply tube 5. FIGS. 5A to 5C are explanatory diagrams relating to disposition of gas ejection port.

The gas supply tube 5 is a cylindrical tube. A plate-like partition member 5a extending along the height direction (axial direction) is provided inside the gas supply tube 5. The partition member 5a traverses the gas supply tube 5 in the diameter direction so as to include the central axis (rotation axis 22) of the gas supply tube 5 and substantially bisects the inside of the gas supply tube 5. The partition member 5a partitions the inside of the gas supply tube 5 into a raw material gas group A flowing section (first gas flowing section) 14 and a raw material gas group B flowing section (second gas flowing section) 15. The raw material gas group A flowing section 14 and the raw material gas group B flowing section 15 respectively extend over the entire height direction of the gas supply tube 5.

As illustrated in FIG. 2, the lower end of the partition member 5a is connected to the upper end of the partition member35. The raw material gas group A flowing section 14 is connected to the raw material gas group A introduction path 31, and the raw material gas group B flowing section 15 is connected to the raw material gas group B introduction path 32. Therefore, a raw material gas group A flowing path supplied from a raw material gas group A source 41, and a raw material gas group B flowing path supplied from a raw material gas group B source 42 are partitioned by the partition member 35 and the partition member 5a and are mutually independent flow paths.

As illustrated in FIGS. 3 and 4, the gas supply tube 5 is provided with a plurality of raw material gas group A ejection ports (first gas ejection ports) 16 and a plurality of raw material gas group B ejection ports (second gas ejection ports) 17a and 17b respectively penetrating the gas supply tube 5. The raw material gas group A ejection port 16 ejects the raw material gas group A from the raw material gas group A flowing section 14 to the internal space of the reaction chamber 6. The raw material gas group B ejection ports 17a and 17b eject the raw material gas group B from the raw material gas group B flowing section 15 to the internal space of the reaction chamber 6. The raw material gas group A ejection port 16 and the raw material gas group B ejection ports 17a and 17b are provided at a plurality of places along the length direction (height direction) of the gas supply tube 5 (refer to FIG. 4).

In the gas supply tube 5 of the embodiment, as illustrated in FIGS. 3 and 4, the raw material gas group A ejection port 16 and the raw material gas group B ejection port 17a and 17b are provided at substantially the same height position as each other. As illustrated in FIG. 4, a set of ejection ports 24 are configured with three gas ejection ports (raw material gas group A ejection port 16 and raw material gas group B ejection port 17a and 17b) lying next to each other in the circumferential direction as one set. In the gas supply tube 5, a plurality of sets of ejection ports 24 are provided in the height direction.

The height positional relationship between the raw material gas group A ejection port 16 and the raw material gas group B ejection ports 17a and 17b constituting the set of ejection ports 24 is a positional relationship in which all of the raw material gas group A ejection port 16 and the raw material gas group B ejection ports 17a and 17b intersect with one plane 23, the normal of which is the rotation axis 22 illustrated in FIG. 4. In this embodiment, such a positional relationship is defined as a "lying next to each other in the circumferential direction" positional relationship.

As a specific example, as illustrated in FIG. 5A, in a case where the raw material gas group A ejection port 16 and the raw material gas group B ejection ports 17a and 17b constituting the set of ejection ports 24 are at the same height as each other, and as illustrated in FIG. 5B, in a case where a portion of the raw material gas group A ejection port 16 and a portion of the raw material gas group B ejection ports 17a and 17b constituting the set of ejection ports 24 are at the same height as each other, these ejection ports correspond to the "lying next to each other in the circumferential direction" positional relationship. On the other hand, as illustrated in FIG. 5C, among the raw material gas group A ejection port 16 and the raw material gas group B ejection ports 17a and 17b, in a case where the two gas ejection ports are provided at different heights in their entirety (in the drawing, raw material gas group A ejection port 16 and raw material gas group B ejection port 17a), the gas ejection ports do not correspond to the "lying next to each other in the circumferential direction" positional relationship.

The raw material gas group A ejection port 16 and the raw material gas group B ejection port 17a and 17b illustrated in FIG. 3 are ejection ports belonging to the same set of ejection ports 24. In the set of ejection ports 24, the relative angle α of the two raw material gas group B ejection ports 17a and 17b communicating with the raw material gas group B flowing section 15 is 120°. The relative angle α can be changed within the range of 60° or more and less than 180°. In a case where the relative angle α is less than 60°, variation in the film quality of the film formed on the work surface increases. The relative angle α is preferably in the range of 120° or more and less than 180°.

In the case of the embodiment, the relative angle α is defined as an angle between a center 18a of an outer peripheral side opening end of one raw material gas group B ejection port 17a, and a center 18b of an outer peripheral side opening end of the other raw material gas group B ejection port 17b, around the axis centered on a center 13 (rotation axis 22) of the gas supply tube 5. Since the relative angle α is an angle around the axis, in a case where the positions in the height direction of the centers 18a and 18b are different, the relative angle α is an angle when the centers 18a and 18b are projected on a plane orthogonal to the rotation axis 22.

In the embodiment, although a case where a plurality of ejection ports communicating with the raw material gas group B flowing section 15 is provided has been described, a plurality of the ejection ports communicating with the raw material gas group A flowing section 14 may be provided. There are no particular limitations as long as the number of ejection ports constituting the set of ejection ports 24 is three or more.

### (Chemical vapor deposition method)

In a chemical vapor deposition method using the chemical vapor deposition apparatus 10, the raw material gas group A and the raw material gas group B are supplied from the raw material gas group A source 41 and the raw material gas group B source 42 to the gas feeding part 3 while rotating the gas supply tube 5 around the axis of the rotation axis 22 by the motor 2.

The rotation speed of the gas supply tube 5 is preferably in the range of 10 rotations or more per minute and 60 rotations or less per minute. The rotation speed is more preferably in the range of 20 rotations or more per minute and 60 rotations or less per minute, and still more preferably in the range of 30 rotations or more per minute and 60 rotations or less per minute or less. Thereby, a uniform film can be obtained in a predetermined large area in the reaction chamber 6. When the raw material gas group is ejected from the rotating gas supply tube 5, this is because the raw material gas group A and the raw material gas group B are uniformly diffused while being respectively stirred by the swirling component due to the rotational motion of the gas supply tube 5. The rotation speed of the gas supply tube 5 is adjusted according to the type of gas and the level of reaction activity of the raw material gas group A and the raw material gas group B. In a case where the rotation speed exceeds 60 rotations per minute, since the raw material gas is mixed in the vicinity of the gas supply tube 5, troubles such as occlusion of the ejection port are likely to occur.

As the raw material gas group A, one or more types of gases selected from an inorganic raw material gas free of a metal element and an organic raw material gas, and a carrier gas can be used. As the raw material gas group B, one or more types of gases selected from the inorganic raw material gas and the organic raw material gas, and the carrier gas can be used. The raw material gas group B is a gas containing at least one or more types of metal.

For example, NH₃ and carrier gas (H₂) are selected as the raw material gas group A, and AlCl₃, TiCl₄, N₂, and carrier gas (H₂) are selected as the raw material gas group B to perform chemical vapor deposition. Therefore, a surface coated cutting tool having a hard layer of an AlTiN layer can be produced.

In addition, for example, NH₃ and carrier gas (H₂) are selected as the raw material gas group A, and AlCl₃, ZrCl₄, N₂, and carrier gas (H₂) are selected as the raw material gas group B to perform chemical vapor deposition. Therefore, a surface coated cutting tool having a hard layer of an AlZrN layer can be produced.

In addition, for example, NH₃ and carrier gas (H₂) are selected as the raw material gas group A, and TiCl₄, SiCl₄, N₂, and carrier gas (H₂) are selected as the raw material gas group B to perform chemical vapor deposition. Therefore, a surface coated cutting tool having a hard layer of a TiSiN layer can be produced.

In addition, for example, NH₃ and carrier gas (H₂) are selected as the raw material gas group A, and AlCl₃, TiCl₄, ZrCl₄, N₂, and carrier gas (H₂) are selected as the raw material gas group B to perform chemical vapor deposition. Therefore, a surface coated cutting tool having a hard layer of an AlTiZrN layer can be produced.

The raw material gas group A supplied from the raw material gas group A source 41 is ejected from the raw material gas group A ejection port 16 to the internal space of the reaction chamber 6 via the raw material gas group A introduction pipe 29, the raw material gas group A inlet 27, the raw material gas group A introduction path 31, and the raw material gas group A flowing section 14.

In addition, the raw material gas group B supplied from the raw material gas group B source 42 is ejected from two raw material gas group B ejection ports 17a and 17b to the internal space of the reaction chamber 6 via the raw material gas group B introduction pipe 30, the raw material gas group B inlet 28, the raw material gas group B introduction path 32, and the raw material gas group B flowing section 15.

The raw material gas group A and the raw material gas group B ejected from the gas supply tube 5 are mixed in the reaction chamber 6 outside the gas supply tube 5, and a hard layer is deposited on the surface of the cutting tool body on the tray 8a by chemical vapor deposition.

In the chemical vapor deposition apparatus 10 of the embodiment, the raw material gas group A and the raw material gas group B are not mixed but separated in the gas supply tube 5 and are ejected from the rotating gas supply tube 5, and thereafter mixed in the reaction chamber 6. In this manner, the raw material gas groups A and B are separated and supplied, so that it is possible to prevent the inside of the gas supply tube 5 from being occluded by a reaction product, and the ejection port from being occluded by a deposited film component.

In addition, according to this configuration, it is possible to adjust the progress of gas mixing and the arrival time of the gas to the surface of the cutting tool body, so that a hard layer having a uniform film quality can be formed up to a cutting tool at a position distant from the gas supply tube 5. This action and effect will be described in detail below.

The raw material gas group A and the raw material gas group B ejected from the gas supply tube 5 have a relatively high concentration in the vicinity of the gas supply tube 5, and are diffused to a uniform concentration away from the gas supply tube 5 in the radial direction. Therefore, the film quality of the hard layer (film) formed when the raw material gas group A and the raw material gas group B are mixed in the vicinity of the gas supply tube 5 differs from the film quality of the hard layer formed when mixed at a position distant from the gas supply tube 5. As a result, it is impossible to obtain the hard layer having the uniform film quality over a desired large area.

In addition, in a case where two or more types of raw material gases are present in the raw material gas group A, there may be a case where a difference in film quality occurs due to a difference in reactivity with the gases of the raw material gas group B in these two types of raw material gas. For example, in a case where the gases A1 and A2 are included in the raw material gas group A, when the reactivity of the gas A2 to the gas B1 of the raw material gas group B is higher than that of the gas A1, the reaction between the gas A2 and the gas B1 is likely to proceed in the vicinity of the gas supply tube 5. As a result, the film quality varies depending on the distance from the gas supply tube 5.

Therefore, in the chemical vapor deposition apparatus 10 of the embodiment, three ejection ports (raw material gas group A ejection port 16, raw material gas group B ejection ports 17a, and 17b) lying next to each other in the circumferential direction of the gas supply tube 5 are provided. Therefore, since gas is ejected from three side surfaces of the gas supply tube 5, it is possible to easily adjust the concentration of the raw material gas groups A and B in the vicinity of the gas supply tube 5. In addition, by adjusting the interval of the ejection ports in the circumferential direction, it is possible to freely adjust a mixing timing of the raw material gas group A and the raw material gas group B. Therefore, according to the embodiment, it is possible to change a mixing state of the raw material gas group A and the raw material gas group B around the axis to make a mixing state of the gas group in consideration of the reactivity between the gases. As a result, in the chemical vapor deposition apparatus 10 of the embodiment, a uniform reaction occurs in the reaction chamber 6, and a hard layer can be formed with a uniform film quality for a plurality of cutting tool bodies mounted on the tray 8a.

The uniformity of the film quality of the hard layer depends on the mutual reaction activity of the raw material gas group A and the raw material gas group B. In the case of the embodiment, by adjusting the rotation speed of the gas supply tube 5, a contact distance of the raw material gas group A and the raw material gas group B can be controlled. Therefore, by adjusting the rotation speed according to the type of the raw material gas group, the uniformity of the film quality can be further improved.

In addition, in the chemical vapor deposition apparatus 10 of the embodiment, as illustrated in FIG. 4, a plurality of sets of the ejection ports 24 lying next to each other in the circumferential direction are provided in the height direction (axial direction) of the gas supply tube 5. As a result, the raw material gas group A and the raw material gas group B uniformly diffuse and mix in the radial direction without respectively staying in each stage (tray 8a) of the work accommodation portion 8, so that it is possible to form a uniform hard layer in a wide area on the tray 8a.

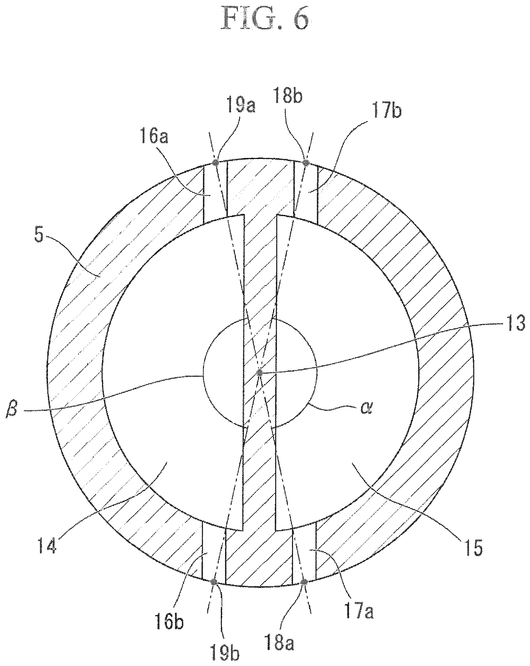

In the embodiment, the case in which the set of ejection ports 24 is configured to include three ejection ports is described, but as illustrated in FIG. 6, four ejection ports may be provided. The gas supply tube 5 illustrated in FIG. 6 has two raw material gas group A ejection ports 16a and 16b, and two raw material gas group B ejection ports 17a and 17b. Even in a case of such a configuration, by adjusting the positions of the four ejection ports, it is possible to adjust the concentration of the raw material gas group A and the raw material gas group B in the vicinity of the gas supply tube 5, and the mixing timing of the gases, thereby a hard layer of uniform film quality can be formed.

A relative angle β around the axis of the two raw material gas group A ejection ports 16a and 16b illustrated in FIG. 6 can be changed within the range of 60° or more and less than 180°. In a case where the relative angle β is less than 60°, variation in the film quality of the film formed on the work surface increases. The relative angle β is preferably in the range of 120° or more and less than 180°.

The relative angle β is defined as an angle between a center 19a of an outer peripheral side opening end of one raw material gas group A ejection port 16a, and a center 19b of an outer peripheral side opening end of the other raw material gas group A ejection port 16b, around the axis centered on a center 13 (rotation axis 22) of the gas supply tube 5. Since the relative angle β is an angle around the axis, in a case where the positions in the height direction of the centers 19a and 19b are different, the relative angle β is an angle when the centers 19a and 19b are projected on a plane orthogonal to the rotation axis 22.

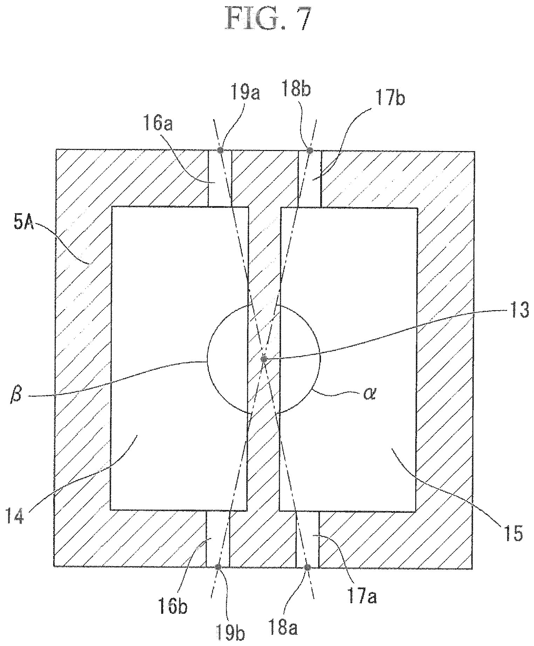

In addition, in the embodiment, although the case where the gas supply tube 5 is a cylindrical tube is described, as illustrated in FIG. 7, a gas supply tube 5A including a square tube having a rectangular cross section may be used. The gas supply tube 5A illustrated in FIG. 7 has four ejection ports (raw material gas group A ejection port 16a, 16b, raw material gas group B ejection port 17a, and 17b), but may have a configuration having three ejection ports illustrated in FIG. 3. In addition, the gas supply tube is not limited to rectangular cross section, and the gas supply tube including a hexagonal or octagonal square tube may be used.

### [Example]

In the example, the chemical vapor deposition apparatus 10 (hereinafter simply referred to as "the example apparatus") of the embodiment described with reference to FIGS. 1 to 5C was used. The diameter of the bell-shaped reaction chamber 6 was 250 mm, and the height was 750 mm. A heater capable of heating the inside of the reaction chamber 6 to 700°C to 1,050°C was used as the outside thermal heater 7. A ring-shaped jig having an outer diameter of 220 mm and having a central hole with a diameter of 65 mm formed in the center was used as the tray 8a.

On the jig (tray 8a), a WC-based cemented carbide body having the shape of JIS standard CNMG 120408 (thickness: 4.76 mm × inscribed circle diameter: 80° rhomboid with 12.7 mm) was mounted as the deposition material.

The deposition material including the WC-based cemented carbide body was mounted at an interval of 20 mm to 30 mm along the radial direction of the jig (tray 8a) and was mounted so as to be substantially equal intervals along the circumferential direction of the jig.

Various raw material gas groups A and raw material gas groups B are supplied to the gas supply tube 5 at a predetermined flow rate using the example apparatus, and the raw material gas group A and the raw material gas group B were ejected into the reaction chamber 6 while rotating the gas supply tube 5. As a result, hard layers (hard films) of Examples 1 to 12 and Comparative Examples 1 to 4 were formed on the surface of the deposition material including the WC-based cemented carbide body by chemical vapor deposition.

Table 1 illustrates the components and compositions of the raw material gas group A and the raw material gas group B used for chemical vapor deposition.

Table 2 illustrates various conditions of chemical vapor deposition in Examples 1 to 12 and Comparative Examples 1 to 4.

The unit "SLM" indicated in Table 2 is a standard flow rate L/min (Standard). The standard flow rate refers to the volume flow rate per minute converted to 1 atm at 20°C.

In addition, the unit "rpm" indicated in Table 2 refers to the number of rotations per minute, and here means the rotation speed of the gas supply tube 5.

**[Table 1]**

| | Conditions | | |
|---|---|---|---|
| | Deposited film type | Compositions of raw material gas (%) | |
| | | Raw material gas group A | Raw material gas group B |
| Example 1 | AlTiN | NH₃: 5%, H₂: 25% | AlCl₃: 1.5%, TiCl₄: 0.5%, N₂: 5%, H₂: 68% |
| Example 2 | AlTiN | NH₃: 5%, N₂: 10%, H₂: 35% | AlCl₃: 2.5%, TiCl₄: 0.5%, N₂: 7%, H₂: 40% |
| Example 3 | AlTiN | NH₃: 5%, N₂: 10%, H₂: 35% | AlCl₃: 2.5%, TiCl₄: 0.5%, N₂: 7%, H₂: 40% |
| Example 4 | AlZrN | NH₃: 5%, H₂: 25% | AlCl₃: 1.3%, ZrCl₄: 0.7%, N₂: 5%, H₂: 68% |
| Example 5 | AlZrN | NH₃: 5%, N₂: 10%, H₂: 35% | AlCl₃: 2.3%, ZrCl₄: 0.7%, N₂: 7%, H₂: 40% |
| Example 6 | AlZrN | NH₃: 5%, N₂: 10%, H₂: 35% | AlCl₃: 2.3%, ZrCl₄: 0.7%, N₂: 7%, H₂: 40% |
| Example 7 | TiSiN | NH₃: 5%, H₂: 25% | TiCl₄: 1.5%, SiCl₄: 0.5%, N₂: 5%, H₂: 68% |
| Example 8 | TiSiN | NH₃: 5%, N₂: 10%, H₂: 35% | TiCl₄: 2.5%, SiCl₄: 0.5%, N₂: 7%, H₂: 40% |
| Example 9 | TiSiN | NH₃: 5%, N₂: 10%, H₂: 35% | TiCl₄: 2.5%, SiCl₄: 0.5%, N₂: 7%, H₂: 40% |
| Example 10 | AlTiZrN | NH₃: 5%, H₂: 25% | AlCl₃: 1.5%, TiCl₄: 0.3%, ZrCl₄: 0.2 %, N₂: 5%, H₂: 68% |
| Example 11 | AlTiZrN | NH₃: 5%, N₂: 10%, H₂: 35% | AlCl₃: 2.5%, TiCl₄: 0.3%, ZrCl₄: 0.2 %, N₂: 7%, H₂: 40% |
| Example 12 | AlTiZrN | NH₃: 5%, N₂: 10%, H₂: 35% | AlCl₃: 2.5%, TiCl₄: 0.3%, ZrCl₄: 0.2 %, N₂: 7%, H₂: 40% |
| | | | |

| | Conditions | | |
|---|---|---|---|
| | Deposited film type | Compositions of raw material gas (%) | |
| | | Raw material gas group A | Raw material gas group B |
| Comparative Example 1 | AlTiN | NH₃: 5%, N₂: 10%, H₂: 35% | AlCl₃: 2.5% TiCl₄: 0.5%, N₂: 7%, H₂: 40% |
| Comparative Example 2 | AlZrN | NH₃: 5%, N₂: 10%, H₂: 35% | AlCl₃: 2.7%, ZrCl₄: 0.3%, N₂: 7%, H₂: 40% |
| Comparative Example 3 | TiSiN | NH₃: 5%, N₂: 10%, H₂: 35% | TiCl₄: 2.5%, SiCl₄: 0.5%, N₂: 7%, H₂: 40% |
| Comparative Example 4 | AlTiZrN | NH₃: 5%, N₂: 10%, H₂: 35% | AlCl₃: 2.5%, TiCl₄: 0.3%, ZrCl₄: 0.2%, N₂: 7%, H₂: 40% |

**[Table 2]**

| | Deposition conditions | | | | | | | | |
|---|---|---|---|---|---|---|---|---|---|
| | Raw material gas flow rate (SLM) | | Deposition temperature (°C) | Deposition pressure (kPa) | Rotation speed (rpm) ^{(note 1)} | Raw material gas group A ejection port | | Raw material gas group B ejection port | |
| | Raw material gas group A | Raw material gas group B | | | | Number of ejection port disposition (piece) ^{(note 2)} | Relative angle of ejection port (°) ^{(note 3)} | Number of ejection port disposition (piece) ^{(note 4)} | Relative angle of ejection port (°) ^{(note 5)} |
| Example 1 | 9 | 21 | 800 | 4 | 30 | 2 | 155 | 2 | 155 |
| Example 2 | 12.0 | 12.0 | 800 | 4 | 10 | 2 | 120 | 1 | - |
| Example 3 | 12.0 | 12.0 | 800 | 4 | 10 | 2 | 50 | 1 | - |
| Example 4 | 9 | 21 | 850 | 5 | 30 | 2 | 155 | 2 | 155 |
| Example 5 | 7.5 | 7.5 | 850 | 5 | 20 | 2 | 120 | 1 | - |
| Example 6 | 7.5 | 7.5 | 850 | 5 | 20 | 2 | 50 | 1 | - |
| Example 7 | 9 | 21 | 800 | 4 | 60 | 2 | 155 | 2 | 155 |
| Example 8 | 10.0 | 10.0 | 800 | 4 | 10 | 1 | - | 2 | 120 |
| Example 9 | 10.0 | 10.0 | 800 | 4 | 10 | 1 | - | 2 | 50 |
| Example 10 | 9 | 21 | 850 | 4 | 20 | 2 | 155 | 2 | 155 |
| Example 11 | 10.0 | 10.0 | 850 | 4 | 10 | 2 | 120 | 1 | - |
| Example 12 | 10.0 | 10.0 | 850 | 4 | 10 | 2 | 50 | 1 | - |
| | | | | | | | | | |

| | Deposition conditions | | | | | | | | |
|---|---|---|---|---|---|---|---|---|---|
| | Raw material gas flow rate (SLM) | | Deposition temperature (°C) | Deposition pressure (kPa) | Rotation speed (rpm) ^{(note 1)} | Raw material gas group A ejection port | | Raw material gas group B ejection port | |
| | Raw material gas group A | Raw material gas group B | | | | Number of ejection port disposition (piece) ^{(note 2)} | Relative angle of ejection port (°) ^{(note 3)} | Number of ejection port disposition (piece) ^{(note 4)} | Relative angle of ejection port (°) ^{(note 5)} |
| Comparative Example 1 | 12.0 | 12.0 | 800 | 4 | 10 | 1 | - | 1 | - |
| Comparative Example 2 | 7.5 | 7.5 | 850 | 5 | 20 | 1 | - | 1 | - |
| Comparative Example 3 | 10.0 | 10.0 | 800 | 4 | 10 | 1 | - | 1 | - |
| Comparative Example 4 | 10.0 | 10.0 | 850 | 4 | 10 | 1 | - | 1 | - |

| | | | | | | | | | |
|---|---|---|---|---|---|---|---|---|---|
| (Note 1) It means the rotation speed of the gas supply tube 5. (Note 2) It means the number of the raw material gas group A ejection ports (first gas ejection ports) that eject the raw material gas group A (first gas) flowing in the raw material gas group A flowing section (first gas flowing section) 14 into the reaction chamber. (Note 3) It means the relative angle around the rotation axis between the ejection ports provided in the raw material gas group A ejection ports (first gas ejection ports) that eject the raw material gas group A (first gas) flowing in the raw material gas group A flowing section (first gas flowing section) 14 into the reaction chamber. "- (hyphen)" means that the relative angle cannot be defined, since there is only one raw material gas group A ejection port (first gas ejection port), (Note 4) It means the number of the raw material gas group B ejection ports (second gas ejection ports) that eject the raw material gas group B (second gas) flowing in the raw material gas group B flowing section (second gas flowing section) 15 into the reaction chamber. (Note 5) It means the relative angle around the rotation axis between the ejection ports provided in the raw material gas group B ejection ports (second gas ejection ports) that eject the raw material gas group B (second gas) flowing in the raw material gas group B flowing section (second gas flowing section) 15 into the reaction chamber. "- (hyphen)" means that the relative angle cannot be defined, since there is only one raw material gas group B ejection port (second gas ejection port). | | | | | | | | | |

For each sample of Examples 1 to 12 and Comparative Examples 1 to 4, the film quality uniformity of the deposited hard coating was examined. Regarding each condition, with respect to the 10 WC-based cemented carbide bodies mounted on the inner peripheral side close to the center hole of the ring-shaped jig (tray 8a), the composition of the hard film deposited on the surface was measured with an electron-probe-micro-analyser (EPMA) to obtain the content ratio of the specific element in various films.

Specifically, in the AlTiN film, the average content ratio (atomic ratio) Al/Al + Ti (atomic%) of Al to the total amount of Al and Ti was obtained. In the AlZrN film, the average content ratio (atomic ratio) Al/Al + Zr (atomic%) of Al to the total amount of Al and Zr was obtained. In the TiSiN film, the average content ratio (atomic ratio) Ti/Ti + Si (atomic%) of Ti to the total amount of Ti and Si was obtained. In the AlTiZrN film, the average content ratio (atomic ratio) Al/Al + Ti + Zr (atomic%) of Al to the total amount of Al, Ti, and Zr was obtained.

In addition, the average content ratio (atomic ratio) of Al or Ti was obtained for ten WC-based cemented carbide bodies mounted on the outer peripheral side of the ring-shaped jig (tray 8a) in the same manner as described above. Furthermore, the difference between "average content ratio (atomic ratio) of Al or Ti in the film formed on the body on the inner peripheral side of the jig" and "average content ratio (atomic ratio) of Al or Ti in the film formed on the body on the outer peripheral side of the jig" was obtained as "difference in the average content ratio (atomic ratio) of Al or Ti on the inner peripheral side and the outer peripheral side". Tables 3 and 4 illustrate each value obtained above.

**[Table 3]**

| | Deposited film type | Average content ratio (atomic ratio) of to the total amount of and Ti by EPMA analysis in the film formed on the body on the inner peripheral side of the jig Al/Al + Ti | Average content ratio (atomic ratio) of Al to the total amount of and Ti by EPMA analysis in the film formed on the body on the outer peripheral side of the jig Al/Al + Ti | Difference in the average content ratio (atomic ratio) of to the total amount of and Ti by EPMA analysis on the inner peripheral side and the outer peripheral side |
|---|---|---|---|---|
| Example 1 | AlTiN | 0.84 | 0.83 | 0.01 |
| Example 2 | AlTiN | 0.87 | 0.85 | 0.02 |
| Example 3 | AlTiN | 0.89 | 0.85 | 0.04 |
| Comparative Example 1 | AlTiN | 0.87 | 0.79 | 0.08 |
| | | | | |

| | Deposited film type | Average content ratio (atomic ratio) of Al to the total amount of Al and Zr by EPMA analysis in the film formed on the body on the inner peripheral side of the jig Al/Al + Zr | Average content ratio (atomic ratio) of Al to the total amount of Al and Zr by EPMA analysis in the film formed on the body on the outer peripheral side of the jig Al/Al + Zr | Difference in the average content ratio (atomic ratio) of Al to the total amount of Al and Zr by EPMA analysis on the inner peripheral side and the outer peripheral side |
|---|---|---|---|---|
| Example 4 | AlZrN | 0.75 | 0.74 | 0.01 |
| Example 5 | AlZrN | 0.77 | 0.74 | 0.03 |
| Example 6 | AlZrN | 0.75 | 0.72 | 0.03 |
| Comparative Example 2 | AlZrN | 0.76 | 0.68 | 0.08 |

**[Table 4]**

| | Deposited film type | Average content ratio (atomic ratio) of Ti to the total amount of Ti and Si by EPMA analysis in the film formed on the body on the inner peripheral side of the jig Ti/Ti + Si | Average content ratio (atomic ratio) of Ti to the total amount of Ti and Si by EPMA analysis in the film formed on the body on the outer peripheral side of the jig Ti / Ti + Si | Difference in the average content ratio (atomic ratio) of Ti to the total amount of Ti and Si by EPMA analysis on the inner peripheral side and the outer peripheral side |
|---|---|---|---|---|
| Example 7 | TiSiN | 0.87 | 0.85 | 0.02 |
| Example 8 | TiSiN | 0.92 | 0.91 | 0.01 |
| Example 9 | TiSiN | 0.92 | 0.90 | 0.02 |
| Comparative Example 3 | TiSiN | 0.91 | 0.84 | 0.07 |
| | | | | |

| | Deposited film type | Average content ratio (atomic ratio) of Al to the total amount of Al, Ti, and Zr by EPMA analysis in the film formed on the body on the inner peripheral side of the jig Al/Al + Ti + Zr | Average content ratio (atomic ratio) of Al to the total amount of Al, Ti, and Zr by EPMA analysis in the film formed on the body on the outer peripheral side of the jig Al/Al + Ti + Zr | Difference in the average content ratio (atomic ratio) of Al to the total amount of Al, Ti, and Zr by EPMA analysis on the inner peripheral side and the outer peripheral side |
|---|---|---|---|---|
| Example 10 | AlTiZrN | 0.80 | 0.79 | 0.01 |
| Example 11 | AITiZrN | 0.81 | 0.79 | 0.02 |
| Example 12 | AlTiZrN | 0.83 | 0.79 | 0.04 |
| Comparative Example 4 | AlTiZrN | 0.82 | 0.68 | 0.14 |

From the results of Tables 3 and 4, in Examples 1 to 12 in which at least three or more in total of the raw material gas group A ejection port 16, the raw material gas group B ejection port 17a, and 17b in the set of ejection ports 24 are disposed, lying next to each other in the circumferential direction of the rotation axis, even in a case where gases having high reaction activity with each other are used as the raw material gas group, "difference in the average content ratio (atomic ratio) of Al or Ti on the inner peripheral side and the outer peripheral side" was extremely small as 0.04 or less (atomic ratio). Therefore, it was confirmed that a hard coating of uniform film quality was formed regardless of where the body was mounted on any place of the jig (tray 8a) disposed in the reaction chamber 6.

In spite of ammonia gas (NH₃) contained in the raw material gas group A and the ammonia gas having high reaction activity with the metal chloride gas (AlCl₃, TiCl₄, ZrCl₄, and the like) of the raw material gas group B, AlTiN film, AlZrN film, TiSiN film, and AlTiZrN film could be formed in a wide range and uniform film quality on the jig.

In particular, in a case where the relative angle of the ejection port was set to 60° or more, when the " difference in the average content ratio (atomic ratio) of Al or Ti on the inner peripheral side and the outer peripheral side" is 0.03 or less (atomic ratio), more favorable uniformity of the film quality was obtained.

On the other hand, in Comparative Examples 1 to 4 in which two in total of the raw material gas group A ejection port 16 and the raw material gas group B ejection port 17 are disposed, lying next to each other in the circumferential direction of the rotation axis, from the results of Tables 3 and 4, "difference in the average content ratio (atomic ratio) of Al or Ti on the inner peripheral side and the outer peripheral side" was larger than in the examples. From these results, it was confirmed that Comparative Examples 1 to 4 were inferior in uniformity of the film quality as compared with Examples 1 to 12.

### Industrial Applicability

As described above, even in a case of depositing a film by using gases having high reaction activity with each other in the raw material gas group with difficulty in the related art, since it is possible to form a uniform film over a large area, the chemical vapor deposition apparatus and the chemical vapor deposition method of the present invention can sufficiently satisfy the industrial application in terms of energy saving and further cost reduction.

In addition, the chemical vapor deposition apparatus and the chemical vapor deposition method of the present invention is not only very effective in producing a surface coated cutting tool coated with a hard layer but also can be used for various types of deposition material depending on the type of film vapor deposited such as film forming on press mold requiring wear resistance and mechanical parts requiring sliding properties.

### Reference Signs List

5, 5A: Gas supply tube
6: Reaction chamber
10: Chemical vapor deposition apparatus
22: Rotation axis
24: Set of ejection ports
2: Motor (rotary drive device)
14: Raw material gas group A flowing section (first gas flowing section)
15: Raw material gas group B flowing section (second gas flowing section)
16, 16a, 16b: Raw material gas group A ejection port (first gas ejection port)
17a, 17b: Raw material gas group B ejection port (second gas ejection port)

## Claims

1. A chemical vapor deposition apparatus comprising:
a reaction chamber in which a deposition material is accommodated;
a gas supply tube provided in the reaction chamber; and
a rotary drive device configured to rotate the gas supply tube around a rotation axis in the reaction chamber,
wherein an inside of the gas supply tube is partitioned into a first gas flowing section and a second gas flowing section which extend along the rotation axis,
a set of gas ejection ports including at least three or more the gas ejection ports disposed, lying next to each other in the circumferential direction is installed on a tube wall of the gas supply tube, and
the set of gas ejection ports includes at least one of a first gas ejection port that ejects a first gas flowing through the first gas flowing section into the reaction chamber, and at least one of a second gas ejection port that ejects a second gas flowing through the second gas flowing section into the reaction chamber.

2. The chemical vapor deposition apparatus according to claim 1,
wherein in the set of the gas ejection ports, a relative angle of the two gas ejection ports disposed in the same gas flowing section around the rotation axis is 60° or more.

3. The chemical vapor deposition apparatus according to claim 1 or 2,
wherein a plurality of sets of the gas ejection ports are provided in the axial direction of the gas supply tube.

4. The chemical vapor deposition apparatus according to any one of claims 1 to 3, further comprising:
a tray having a mounting surface on which the deposition material is mounted,
wherein the mounting surface of the tray is disposed towards an axial direction of the gas supply tube.

5. The chemical vapor deposition apparatus according to claim 4,
wherein a plurality of the trays are stacked and disposed along the axial direction of the gas supply tube.

6. The chemical vapor deposition apparatus according to claim 4 or 5,
wherein the tray has a through-hole, and the gas supply tube is inserted into the through-hole.

7. A chemical vapor deposition method comprising:
forming a film on a surface of a deposition material by using the chemical vapor deposition apparatus according to any one of claims 1 to 6.

8. The chemical vapor deposition method according to claim 7,
wherein the gas supply tube is rotated at a rotation speed of 10 rotations or more per minute and 60 rotations or less per minute.

9. The chemical vapor deposition method according to claim 7 or 8,
wherein a raw material gas free of a metal element is used as the first gas, and a raw material gas containing the metal element is used as the second gas.

10. The chemical vapor deposition method according to claim 9,
wherein an ammonia-containing gas is used as the first gas.
